# FASCICULE DE BREVET EUROPEEN

(11) **EP 4 070 369 B1**
(45) Date de publication et mention de la délivrance du brevet: **07.05.2025**
(21) Numéro de dépôt: 20820515.3
(22) Date de dépôt: 25.11.2020
(51) Int. Cl.: H01L 21/762, H01L 21/02

(54) **PROCÉDÉ DE FORMATION D'UN SUBSTRAT DE MANIPULATION POUR UNE STRUCTURE COMPOSITE CIBLANT DES APPLICATIONS RF ET SUBSTRAT DE MANIPULATION**
VERFAHREN ZUR HERSTELLUNG EINES HANDHABUNGSSUBSTRATS FÜR EINE VERBUNDSTRUKTUR FÜR RF-ANWENDUNGEN UND HANDHABUNGSSUBSTRAT
METHOD FOR FORMING A HANDLING SUBSTRATE FOR A COMPOSITE STRUCTURE INTENDED FOR RF APPLICATIONS AND HANDLING SUBSTRATE

(30) Priorité: 05.12.2019 FR 1913780
(43) Date de publication de la demande: 12.10.2022
(73) Titulaire: SOITEC, 38190 Bernin (FR)
(72) Inventeur: KIM, Young-Pil, 38000 GRENOBLE (FR); DELPRAT, Daniel, 38920 CROLLES (FR); CAPELLO, Luciana, 38000 GRENOBLE (FR); BERTRAND, Isabelle, 38190 BERNIN (FR); ALLIBERT, Frédéric, 38100 GRENOBLE (FR)
(74) Mandataire: IP Trust
(86) Numéro de dépôt international: PCT/FR2020/052171
(87) Numéro de publication internationale: WO 2021/111062

(56) Documents cités:
- EP-A1- 3 574 519
- WO-A1-2017/167923
- WO-A1-2018/080772
- US-A1- 2018 033 681

## Description

### DOMAINE DE L'INVENTION

La présente invention concerne un substrat de manipulation pour substrat composite compatible avec des applications RF haute performance. Elle concerne également un procédé de formation d'un tel substrat de manipulation.

### CONTEXTE TECHNOLOGIQUE DE L'INVENTION

Les substrats de silicium haute résistivité (HR) sont les substrats de manipulation les plus couramment utilisés pour réaliser des dispositifs RF. Un substrat de silicium HR présente habituellement une résistivité supérieure à 1000 ohm.cm et plus généralement supérieure à 5000 ohm.cm.

Des structures composites telles que le SOI (silicium sur isolant) avec des substrats de manipulation en silicium HR, comprenant ou non une couche de piégeage de charge entre le substrat de manipulation et l'oxyde enterré sont bien connues dans le domaine des radiofréquences (RF). En particulier, les structures composites à couche de piégeage de charge garantissent des performances élevées des dispositifs RF réalisés sur lesdites structures, à condition que la couche de piégeage de charge ne subisse pas de dommages quand les structures sont exposées à des températures élevées, par exemple pendant sa fabrication ou pendant la fabrication de dispositifs RF. Par exemple, quand une couche de piégeage de charge en polysilicium recristallise, même partiellement, les performances RF de la structure composite et des dispositifs intégrés qui y sont formés sont affectées, ce qui n'est évidemment pas souhaitable.

Un autre problème provient de l'approvisionnement en substrats HR qui devient de plus en plus restreint, à mettre en parallèle avec l'augmentation de la fabrication de dispositifs RF. En conséquence, le matériau devient de plus en plus cher.

Référence est faite aux documents suivants :
WO 2018/080772 A1 (SUNEDISON SEMICONDUCTOR LTD [SG]) 3 mai 2018 (2018-05-03) ;
US 2018/033681 A1 (ISHIKAWA OSAMU [JP] ET AL) 1 février 2018 (2018-02-01).

### OBJET DE L'INVENTION

La présente invention propose une solution alternative pour fournir un substrat de manipulation adapté à des structures composites sur lesquelles des dispositifs RF haute performance peuvent être réalisés et pour faciliter les processus d'approvisionnement et de fabrication.

### BRÈVE DESCRIPTION DE L'INVENTION

En vue d'atteindre ce but, l'objet de la présente invention propose un procédé de formation d'un substrat de manipulation pour une structure composite selon la revendication indépendante 1 et un substrat de manipulation pour structure composite selon la revendication indépendante 9. Des modes de réalisation préférentiels sont données dans les revendications dépendantes.

La présente invention concerne un procédé de formation d'un substrat de manipulation pour une structure composite, le procédé comprenant :
a) la fourniture d'une tranche de silicium monocristallin obtenue par tirage Czochralski ayant une résistivité comprise entre 10 et 500 ohm.cm ;
b) la croissance d'une couche épitaxiale de silicium sur la tranche de silicium monocristallin obtenue par tirage Czochralski pour former un substrat de base, ladite couche épitaxiale de silicium présentant une résistivité supérieure à 2000 ohm.cm et une épaisseur allant de 2 à 100 microns, micron étant égal à 1 micromètre;
c) la formation d'une couche de passivation sur la couche épitaxiale de silicium, ladite couche de passivation étant amorphe ou polycristalline ;
d) la croissance d'une couche de piégeage de charge polycristalline sur la couche de passivation, le procédé étant caractérisé en ce que l'étape c) comprend :
   - une carbonisation de la surface de la couche épitaxiale (2) de silicium, de façon à former une couche (3) de passivation faite de carbure de silicium polycristallin, la carbonisation s'effectuant sous pression partielle d'un gaz précurseur de carbone inférieure à la pression atmosphérique, ou
   - une nitruration de la surface de la couche épitaxiale (2) de silicium, de façon à former une couche (3) de passivation en nitrure de silicium, la nitruration s'effectuant sous pression partielle d'un gaz précurseur d'azote inférieure à la pression atmosphérique.

Selon d'autres caractéristiques avantageuses et non limitatives de l'invention, prises individuellement ou selon toute combinaison techniquement réalisable :
- la carbonisation de l'étape c) comprend l'exposition du substrat de base à un seul précurseur de carbone à une pression inférieure à la pression atmosphérique pour former une couche de passivation en carbure de silicium polycristallin d'au moins 5 nm d'épaisseur sur la surface de la couche épitaxiale de silicium ;
- ledit seul précurseur de carbone présente une température comprise entre 700 °C et 1200 °C ;
- la couche de passivation présente une épaisseur d'au moins 10 nm ;
- la couche de piégeage de charge a une épaisseur supérieure à 5 ou 10 microns ;
- la couche de piégeage de charge est faite de silicium polycristallin ;
- les étapes b), c) et d) sont toutes effectuées successivement *in situ* dans un équipement d'épitaxie ;
- l'étape b) est exécutée dans un premier réacteur et les étapes c) et d) sont exécutées dans un second réacteur, et dans lequel le transfert du substrat de base du premier réacteur au second réacteur est effectué sans rompre le vide.

### BRÈVE DESCRIPTION DES DESSINS

D'autres caractéristiques et avantages de l'invention apparaîtront à partir de la description détaillée de l'invention ci-après, qui se réfère aux figures ci-jointes parmi lesquelles :
La Figure 1 représente un substrat de manipulation selon l'invention ;
La Figure 2 représente une structure composite selon l'invention.

### DESCRIPTION DÉTAILLÉE DE L'INVENTION

Dans la partie descriptive, on peut utiliser les mêmes références sur les figures pour désigner des éléments du même type. Les figures sont des représentations schématiques qui, à des fins de lisibilité, ne sont pas à l'échelle. En particulier, les épaisseurs des couches suivant l'axe z ne sont pas à l'échelle par rapport aux dimensions latérales suivant les axes x et y ; et les épaisseurs des couches les unes par rapport aux autres ne sont pas nécessairement respectées sur les figures.

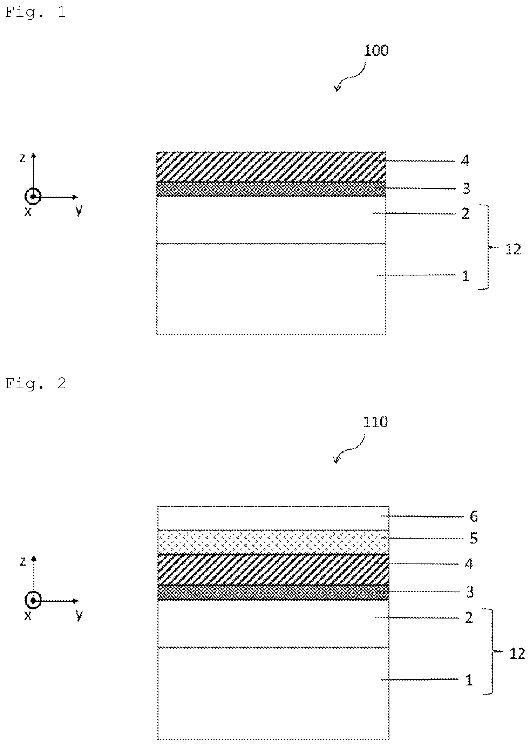

La Figure 1 représente schématiquement un substrat de manipulation 100 pour un substrat composite selon la présente invention. Le substrat de manipulation 100 peut se présenter sous la forme d'une tranche circulaire, de taille normalisée, par exemple 200 mm ou 300 mm, voire 450 mm de diamètre. Cependant, la présente invention n'est en aucune façon limitée à ces dimensions ou à cette forme.

Le substrat de manipulation 100 comprend un substrat de base 12 formé par une couche épitaxiale 2 de silicium disposée sur une tranche 1 de silicium. Ladite tranche 1 de silicium a généralement une épaisseur de plusieurs centaines de microns et présente une résistivité standard allant de 10 à 500 ohm.cm. Il peut s'agir préférentiellement de silicium monocristallin obtenu par tirage Czochralski, qui est un type de matériau largement disponible.

La couche épitaxiale 2 de silicium présente une résistivité supérieure à 2000 ohm.cm, préférentiellement comprise entre 2000 ohm.cm et 20000 ohm.cm. De cette façon, la densité des charges, trous ou électrons susceptibles de se déplacer dans la couche épitaxiale de silicium est limitée. Ladite couche épitaxiale 2 a une épaisseur allant de 2 à 100 microns.

Le substrat de manipulation 100 comprend également, sur le substrat de base 12, une couche 4 de piégeage de charge. La couche 4 de piégeage de charge a pour fonction de piéger tout porteur de charge éventuellement présent dans le substrat de manipulation 100 et de limiter sa mobilité.

Pour des raisons de disponibilité et de coût, la couche 4 de piégeage de charge est préférentiellement en silicium polycristallin. Toutefois, elle peut être formée à partir d'un autre matériau semi-conducteur et polycristallin, ou elle peut comprendre une partie réalisée à partir d'un autre matériau semi-conducteur et polycristallin. Il peut s'agir par exemple de germanium, de silicium-germanium, etc...

Dans tous les cas, la couche 4 de piégeage de charge polycristalline présente une résistivité élevée, généralement supérieure à 3000 ohm.cm. A cet effet, cette couche n'est pas intentionnellement dopée, c'est-à-dire qu'elle présente une concentration en dopants inférieure à 10¹⁴ atomes/cm³. Elle peut être riche en azote ou en carbone pour améliorer sa caractéristique de résistivité.

La couche 4 de piégeage de charge polycristalline peut avoir une épaisseur supérieure à 0,5 micron, ou supérieure à 5 microns, voire supérieure à 10 microns. Que son épaisseur soit supérieure ou inférieure à ces limites, la couche 4 de piégeage de charge peut être composée de grains de taille comprise entre 10 nm et 1000 nm.

Le substrat de manipulation 100 comprend égalementune couche 3 de passivation amorphe ou polycristalline, interposée entre le substrat de base 12 et la couche 4 de piégeage de charge polycristalline. La couche 3 de passivation est formée directement sur la couche épitaxiale 2 de silicium et permet de faire croître sur elle la couche 4 de piégeage de charge polycristalline. Cette couche est nécessaire pour empêcher la couche 4 de piégeage de charge de recristalliser pendant des traitements à haute température.

La couche 3 de passivation peut ainsi rester sous forme amorphe ou polycristalline pendant toute la durée de mise en œuvre des procédés à haute température nécessaires pour fabriquer le substrat de manipulation 100 et, plus tard, la structure composite 110 et les dispositifs RF. Généralement, le budget thermique à supporter par le substrat de manipulation 100 est de l'ordre de quelques heures à 10 heures, à des températures allant de 950 °C à 1200 °C.

La couche 3 de passivation peut être de différentes natures. Avantageusement, elle est constituée d'une couche de carbure de silicium polycristallin formée par carbonisation de la surface libre de la couche épitaxiale 2 de silicium. En variante, elle peut être constituée d'une couche de nitrure de silicium formée par nitruration de la surface de la couche épitaxiale de silicium.

En général, la couche 3 de passivation peut avoir au moins 2 nm d'épaisseur et de préférence au moins 10 nm d'épaisseur.

Le substrat de manipulation 100 est ainsi constitué du substrat de base 12, formé par une couche épitaxiale 2 de silicium disposée sur une tranche 1 de silicium monocristallin, de la couche 3 de passivation directement en contact avec la couche épitaxiale 2 de silicium et d'une couche 4 de piégeage de charge polycristalline sur, et directement en contact avec, la couche 3 de passivation. Il n'est pas prévu d'incorporer d'autres couches, notamment des couches électriquement isolantes, qui pourraient modifier les propriétés du substrat de manipulation 100 proposé.

Le substrat de manipulation 100 peut éventuellement comprendre une couche diélectrique 5 disposée directement sur la couche 4 de piégeage de charge. Ladite couche d'isolant 5, qui est optionnelle, peut faciliter l'assemblage du substrat de manipulation 100 avec un autre substrat. La couche diélectrique 5 peut par exemple être en oxyde de silicium ou en nitrure de silicium.

La Figure 2 représente une structure composite 110 selon la présente invention, qui comprend un substrat de manipulation 100 comme décrit précédemment. Comme il ressort très clairement de cette figure, la structure composite comprend une couche diélectrique 5 sur le substrat de manipulation 100 et un film mince 6, réalisé de préférence en matériau monocristallin, sur la couche diélectrique 5. Par exemple, et sans limitation, le film mince 6 peut être réalisé en matériau semi-conducteur, tel que le silicium, ou en matériau piézoélectrique, tel que le tantalate de lithium (LiTaO₃), le niobate de lithium (LiNbO₃), l'oxyde d'aluminium et de lithium (LiAlO₃), le titanate de baryum (BaTiO₃), le titanate-zirconate de plomb (PbZrTiO₃), le niobate de potassium (KNbO₃), le zirconate de baryum (BaZrO₃), le titanate de calcium (CaTiO₃), le titanate de plomb (PbTiO₃), le tantalite de potassium (KTaO₃), etc...

La structure composite 110 de la Figure 2 peut être formée de plusieurs manières à partir du substrat de manipulation 100, mais avantageusement cette formation comprend une étape de transfert du film mince 6 sur le substrat de manipulation 100. Comme cela est bien connu en soi, on effectue généralement ce transfert en assemblant la face d'un substrat donneur sur le substrat de manipulation 100. Cela peut être réalisé en présence ou non de la couche diélectrique 5.

Quand le film mince 6 est réalisé en matériau piézoélectrique, son orientation cristalline est choisie en fonction de l'application prévue. Pour les filtres à ondes acoustiques de surface réalisés en tantalate de lithium LiTaO₃, il est habituel de choisir une orientation comprise entre 30° et 60° XY, ou entre 40° et 50° XY. Pour le niobate de lithium LiNbO₃, il est courant de choisir une orientation autour de 128° XY. Mais l'invention n'est nullement limitée à une orientation cristalline particulière d'un film mince piézoélectrique. Le substrat donneur peut avoir été prélevé d'un lingot en matériau ferroélectrique de telle sorte que le substrat donneur présente l'orientation cristalline choisie. En variante, le substrat donneur peut comprendre une couche épaisse en matériau ferroélectrique assemblée à un substrat de support.

Après cette étape d'assemblage, on réduit l'épaisseur du substrat donneur afin de former le film mince 6. Cette étape de réduction peut être effectuée par amincissement mécanique ou chimique. Elle peut aussi être exécutée par fracture au niveau d'une zone fragile préalablement introduite dans le substrat donneur, par exemple conformément aux principes de la technologie Smart Cut^{™}.

Des étapes de finition du film mince 6, telles qu'une étape de polissage, un traitement thermique sous atmosphère réductrice ou neutre ou une oxydation sacrificielle peuvent être enchaînées à la suite de l'étape de réduction d'épaisseur.

Quand le substrat donneur est un substrat massif, c'est-à-dire ne comprenant pas de dispositif intégré, on forme une structure composite 110 du type "semi-conducteur sur isolant", dans laquelle le film mince 6 est une couche de semi-conducteur vierge, comprenant le substrat de manipulation 100 selon l'invention. On peut alors utiliser la structure composite 110 pour former des dispositifs intégrés.

Quand le substrat donneur a été préalablement traité afin de former des dispositifs intégrés sur sa surface, un film mince 6 qui comprend lesdits dispositifs peut être transféré sur le substrat de manipulation 100, formant une structure composite 110 avec une couche de dispositifs intégrés sur le substrat de manipulation 100 selon l'invention.

La fabrication du substrat de manipulation 100 selon la présente description est réalisable en se fournissant en matériaux standards et en utilisant un équipement conventionnel d'épitaxie/dépôt de l'industrie.

D'abord, le procédé comprend une étape a) consistant à fournir une tranche 1 de silicium monocristallin obtenue par tirage Czochralski et ayant une résistivité allant de 10 à 500 ohm.cm.

L'étape suivante b) consiste à faire croître une couche épitaxiale 2 de silicium sur la tranche 1 de silicium, pour former un substrat de base 12. Pour ce faire, on place la tranche 1 de silicium dans le réacteur (ou chambre) d'un équipement d'épitaxie. On peut préparer la tranche 1 de silicium avant la croissance épitaxiale, afin de nettoyer sa surface (c'est-à-dire éliminer des dopants organiques ou métalliques ou des contaminations particulaires) et éliminer de sa surface une couche d'oxyde natif. Le nettoyage s'effectue généralement avec des traitements conventionnels de nettoyage humide. La désoxydation peut se faire par gravure chimique, humide ou sèche, avant de charger la tranche 1 de silicium dans le réacteur ; on peut aussi l'effectuer en exposant la tranche 1 de silicium dans le réacteur à une atmosphère réductrice à une température d'au moins 900 °C.

L'étape b) vise à faire croître une couche épitaxiale 2 de silicium intrinsèque. Sa résistivité est supérieure à 2000 ohm.cm et son épaisseur va de 2 à 100 microns.

Avantageusement, la croissance épitaxiale de la couche de silicium s'effectue à des températures élevées, allant de 1000 °C à 1200 °C, sous pression atmosphérique ou réduite avec des sources conventionnelles de silicium gazeux telles que le trichlorosilane (TCS), le dichlorosilane (DCS) ou le silane (SiH₄).

Puis, le procédé selon l'invention comprend une étape c) consistant à former une couche 3 de passivation amorphe ou polycristalline sur la couche épitaxiale 2 de silicium.

Selon une première option, la formation de ladite couche 3 de passivation s'effectue dans le même réacteur que celui utilisé pour la croissance épitaxiale. Ce qui est avantageux puisque le substrat de base 12 reste *in situ,* sous atmosphère contrôlée. D'une part, cela évite une rupture du vide et améliore ainsi le temps brut de traitement et l'efficacité globale du procédé ; d'autre part, cela empêche le substrat de base 12 d'attraper des contaminants provenant de l'atmosphère ambiante, tels que des particules ou des résidus de bore pouvant être présents dans la salle blanche. On peut ainsi protéger et maintenir l'interface entre la couche épitaxiale 2 de silicium et la couche 3 de passivation avec une résistivité élevée.

Selon une deuxième option, la formation de la couche 3 de passivation s'effectue dans un second réacteur partageant le même module de transfert avec le premier réacteur utilisé pour la couche épitaxiale de silicium, sous vide ou atmosphère d'argon ou d'azote. Là encore, le vide n'est pas rompu et le substrat de base 12 reste *in situ,* sous atmosphère contrôlée, évitant les contaminations *ex situ* et garantissant que l'interface entre la couche épitaxiale 2 de silicium et la couche 3 de passivation présente une résistivité élevée. De plus, cette deuxième option facilite le nettoyage des réacteurs. En effet, le matériau épitaxial de silicium déposé sur les paroies intérieures du premier réacteur (de quelques microns à quelques dizaines de microns) pendant la croissance épitaxiale peut être éliminé plus facilement si aucune carbonisation ou nitruration n'a été effectuée par-dessus. La couche 3 de passivation formée par carbonisation ou nitruration dans le second réacteur est formée uniquement sur le matériau silicium, c'est-à-dire uniquement sur la couche épitaxiale en silicium. En conséquence, cela n'a pas d'impact sur les pièces disposés à l'intérieur du second réacteur puisque la carbonisation et la nitruration sont des réactions se produisant entre les gaz sources et la surface de silicium. Le fait de réaliser les étapes b) et c) dans des premier et second réacteurs distincts permet une meilleure gestion du nettoyage et des performances des chambres.

Bien entendu, selon une troisième option, on peut retirer le substrat de base 12 du premier réacteur pour le remettre dans l'atmosphère de la salle blanche. En pareil cas, on peut préparer le substrat de base 12 avant formation de la couche de passivation, afin de nettoyer la surface de la couche épitaxiale de silicium (c'est-à-dire éliminer des dopants organiques ou métalliques ou des contaminants particulaires) et éliminer de ladite surface une couche d'oxyde natif. Le nettoyage peut s'effectuer avec des traitements de nettoyage humide conventionnels. La désoxydation peut se faire par gravure chimique humide ou sèche. La désoxydation peut en variante s'effectuer après chargement du substrat de base 12 dans le réacteur, en l'exposant à une atmosphère réductrice à une température d'au moins 800 °C. Cette étape n'est cependant pas obligatoire et on peut garder cet oxyde natif. Il est en effet suffisamment fin, de 1 à 2 nm d'épaisseur, pour ne pas avoir d'effet isolant (conduction à travers cette couche par effet tunnel) dans la mesure où de futurs traitements thermiques ne l'auront pas fait complètement disparaître par dissolution.

Selon l'une quelconque des options précédemment citées, après avoir été placé dans un réacteur, le substrat de base 12 subit la formation de la couche 3 de passivation.

Selon un premier mode de réalisation, l'étape c) comprend une carbonisation de la surface libre de la couche épitaxiale 2 de silicium, de sorte à former une couche 3 de passivation en carbure de silicium polycristallin.

Pour ce faire, on expose le substrat de base 12, et plus particulièrement la surface libre de la couche épitaxiale 2 de silicium, à un seul gaz précurseur de carbone à une pression inférieure à la pression atmosphérique, comprise par exemple entre 0,01 Torr et 760 Torr, où 1 Torr = 133322 pascals (Pa). Le gaz précurseur de carbone peut être composé de méthane (CH₄), d'éthane (C₂H₆), de propane (C₃H₈), d'acétylène (C₂H₂), d'éthylène (C₂H₄) ... Le gaz précurseur peut être introduit dans le réacteur (ou chauffé à l'intérieur du réacteur) à une température comprise entre 700 °C et 1200 °C, de telle sorte que les espèces carbonées effectuent une nucléation sur la surface de la couche épitaxiale 2 de silicium. Un flux de gaz de transport (tel que H₂) peut aussi être introduit simultanément dans la chambre, mais aucun autre gaz précurseur que le gaz précurseur de carbone ne s'écoule sur le substrat de base 12. En évitant la réaction de l'espèce carbonée avec d'autres espèces d'un second précurseur, le dépôt de composé carboné sur la paroi du réacteur est limité et on évite la génération de particules.

Il a été observé de manière surprenante que lorsque cette étape de carbonisation s'effectue sous pression partielle de carbone réduite, inférieure à 760 Torr, la nucléation de l'espèce carbonée s'effectue sur des îlots isolés sur la surface. Les atomes de silicium de la tranche de base diffusent alors dans les îlots de carbone, formant des îlots de carbure de silicium stœchiométriques ou proches de l'état de stœchiométrie de type 3C/6H et 4H. Les îlots coalescent pour former une couche de carbure de silicium polycristallin relativement épaisse. Quand on maintient le flux de gaz précurseur de carbone pendant quelques minutes, l'épaisseur des couches polycristallines croît jusqu'à plusieurs nanomètres.

Dans un exemple particulier, on introduit un gaz précurseur de carbone en C₃H₈, mélangé à du H₂ dans un rapport 180sccm/5slm, et on le fait circuler pendant 5 minutes à une pression de 10 Torr dans la chambre et on le chauffe à 1000 °C. On observe alors sur la surface de la couche épitaxiale 2 de silicium une couche 3 de passivation polycristalline en carbure de silicium ayant une épaisseur de 10 nm.

Quand l'étape de carbonisation s'effectue à une pression partielle de carbone plus élevée, supérieure à 760 Torr, un phénomène complètement différent a lieu sur la surface du substrat de base 12. Les espèces carbonées effectuent une nucléation avec une grande densité sur la surface et bloquent la diffusion des atomes de silicium à partir de cette surface. Une couche de carbone cristalline ou partiellement cristalline croît alors lentement sur la surface, alignée avec le réseau de silicium, dans une structure 3C. Une telle couche présente typiquement une épaisseur de 2 nm après 10 minutes de dépôt.

Il apparaît par conséquent que faire circuler un seul gaz précurseur de carbone à pression partielle de carbone réduite sur le substrat de base 12 est un moyen très efficace pour former une couche relativement épaisse (supérieure à 5 nm ou 10 nm) de carbure de silicium polycristallin. Une telle couche 3 de passivation est avantageuse parce que, grâce à sa nature polycristalline, elle permet ainsi de préparer et de préserver la nature polycristalline de la couche 4 de piégeage de charge que l'on fait croître sur elle. De plus, l'épaisseur relativement importante de la couche de passivation se forme assez rapidement et constitue une barrière de diffusion efficace pour éviter la migration d'espèces dopantes du substrat de base 3 vers la couche 4 de piégeage de charge.

En outre, il a été observé qu'une telle étape de carbonisation, sous pression partielle de carbone réduite, incorporait très peu de dopants (comme le bore) dans la couche 3 de passivation en carbure de silicium. Des mesures ont montré une concentration en bore inférieure à 10¹⁴ atomes/cm³ dans une telle couche. On croit que les espèces dopantes (éventuellement présentes à la surface du substrat de base 12 ou incorporées dans celui-ci) sont diffusées hors de la couche de carbure de silicium pendant sa formation et évacuées de la chambre de dépôt (ou réacteur) avec le gaz précurseur et de transport.

Selon un second mode de réalisation, l'étape c) comprend une nitruration de la surface libre de la couche épitaxiale 2 de silicium, de façon à former une couche 3 de passivation faite de nitrure de silicium.

Pour ce faire, on expose le substrat de base 12, et plus particulièrement la surface libre de la couche épitaxiale 2 de silicium, à un gaz précurseur d'azote à une pression comprise par exemple entre 0,1 Torr et 760 Torr. Le gaz précurseur peut être composé d'ammoniac (NH₃). Le gaz précurseur peut être introduit dans la chambre (ou chauffé à l'intérieur de la chambre) à une température comprise entre 800 °C et 1300 °C, de telle sorte que les espèces azotées effectuent une nucléation sur la surface de la couche épitaxiale 2 de silicium.

Après l'étape c), on obtient une couche de passivation faite de nitrure de silicium. Une telle couche de passivation présente typiquement une épaisseur inférieure à 10 nm après 10 secondes à 60 minutes de nitruration.

Une telle couche 3 de passivation est avantageuse parce que, grâce à sa nature non épitaxiale sur silicium, elle permet ainsi de préparer et de préserver la nature polycristalline de la couche 4 de piégeage de charge que l'on fait croître sur elle. La couche 3 de passivation se forme assez rapidement seulement sur le silicium et constitue une barrière de diffusion efficace pour éviter la migration d'espèces dopantes du substrat de base 12 vers la couche de piégeage de charge.

Sur la base de l'un quelconque des premier et second modes de réalisation, après la croissance de la couche 3 de passivation sur le substrat de base 12, le réacteur est traversé par un autre flux de gaz précurseur, à une température de l'ordre de 1000 °C, afin de former de manière conventionnelle une couche 4 de piégeage de charge polycristalline : c'est l'étape d) du procédé selon l'invention. La durée de circulation du gaz précurseur détermine l'épaisseur de la couche 4 polycristalline et cette durée peut être choisie de sorte à faire croître une couche de 5 microns, 10 microns ou plus.

Avantageusement, la couche 3 de passivation et la couche 4 de piégeage de charge polycristalline sont formées in situ, dans le même réacteur ou chambre. Cela évite de contaminer l'empilement de couches par des dopants ou des contaminants provenant de l'atmosphère ambiante et préserve les caractéristiques de résistivité élevée du substrat de manipulation 100.

Pour être complet, le substrat de manipulation 100 peut être pourvu d'une couche diélectrique 5, par exemple un oxyde de silicium ou un nitrure de silicium, déposée de manière conventionnelle. Ladite couche diélectrique 5 et/ou la couche 4 de piégeage de charge polycristalline peuvent aussi être polies, afin de fournir une surface supérieure du substrat de manipulation 100 compatible avec une étape conventionnelle de transfert d'un film mince 6 sur ledit substrat de manipulation 100.

Bien entendu l'invention ne se limite pas au mode de réalisation décrit et on peut y apporter des variantes de réalisation sans sortir du cadre de l'invention tel que défini par les revendications.

## Revendications

1. Procédé de formation d'un substrat de manipulation (100) pour une structure composite, le procédé comprenant :
a) la fourniture d'une tranche (1) de silicium monocristallin obtenue par tirage Czochralski ayant une résistivité comprise entre 10 et 500 ohm.cm ;
b) la croissance d'une couche épitaxiale (2) de silicium sur la tranche (1) de silicium monocristallin obtenue par tirage Czochralski pour former un substrat de base (12), ladite couche épitaxiale (2) de silicium présentant une résistivité supérieure à 2000 ohm.cm et une épaisseur allant de 2 à 100 micromètres;
c) la formation d'une couche (3) de passivation sur la couche épitaxiale (2) de silicium, ladite couche (3) de passivation étant amorphe ou polycristalline ;
d) la croissance d'une couche (4) de piégeage de charge polycristalline sur la couche (3) de passivation ;
le procédé étant **caractérisé en ce que** l'étape c) comprend :
- une carbonisation de la surface de la couche épitaxiale (2) de silicium, de façon à former une couche (3) de passivation faite de carbure de silicium polycristallin, la carbonisation s'effectuant sous pression partielle d'un seul gaz précurseur de carbone inférieure à la pression atmosphérique, ou
- une nitruration de la surface de la couche épitaxiale (2) de silicium, de façon à former une couche (3) de passivation en nitrure de silicium, la nitruration s'effectuant sous pression partielle d'un gaz précurseur d'azote à une pression comprise entre 0,1 Torr, c'est-à-dire 13,3322 Pa et 760 Torr, c'est-à-dire 101325 Pa.

2. Procédé selon la revendication précédente, dans lequel la carbonisation de l'étape c) comprend l'exposition du substrat de base (12) à un seul précurseur de carbone à une pression inférieure à la pression atmosphérique pour former une couche (3) de passivation de carbure de silicium polycristallin d'au moins 5 nm sur la surface de la couche épitaxiale (2) de silicium.

3. Procédé selon la revendication précédente, dans lequel ledit seul précurseur de carbone présente une température comprise entre 700 °C et 1200 °C.

4. Procédé selon l'une quelconque des revendications 1 à 3, dans lequel la couche (3) de passivation présente une épaisseur d'au moins 10 nm.

5. Procédé selon l'une quelconque des revendications 1 à 4, dans lequel la couche (4) de piégeage de charge a une épaisseur supérieure à 5 ou 10 micromètres.

6. Procédé selon l'une quelconque des revendications 1 à 5, dans lequel la couche (4) de piégeage de charge est en silicium polycristallin.

7. Procédé selon l'une quelconque des revendications 1 à 6, dans lequel les étapes b), c) et d) sont toutes effectuées successivement *in situ* dans un équipement d'épitaxie.

8. Procédé selon la revendication précédente, dans lequel l'étape b) est exécutée dans un premier réacteur et les étapes c) et d) sont exécutées dans un second réacteur, et dans lequel le transfert du substrat de base (12) du premier réacteur au second est effectué sans rupture du vide.

9. Substrat de manipulation (100) pour structure composite, issu du procédé selon l'une des revendications 1 à 8.

10. Structure composite (110) pour applications radiofréquence comprenant :
- un substrat de manipulation (100) selon la revendication précédente,
- une couche diélectrique (5) sur et en contact avec la couche (4) de piégeage de charge,
- un film mince (6) sur la couche diélectrique (5), adapté à des dispositifs radiofréquence.

## Patentansprüche

1. Verfahren zum Ausbilden eines Handhabungssubstrats (100) für eine Verbundstruktur, das Verfahren umfassend:
a) Bereitstellen eines durch Czochralski-Ziehen erhaltenen Wafers (1) aus monokristallinem Silizium, der einen spezifischen Widerstand zwischen 10 und 500 Ohm.cm besitzt;
b) Wachstum einer epitaktischen Schicht (2) aus Silizium auf dem durch Czochralski-Ziehen erhaltenen Wafer (1) aus monokristallinem Silizium zum Ausbilden eines Basissubstrats (12), wobei die epitaktische Schicht (2) aus Silizium einen spezifischen Widerstand von über 2000 Ohm.cm und eine Dicke von 2 bis 100 Mikrometern aufweist;
c) Ausbilden einer Passivierungsschicht (3) auf der epitaktischen Schicht (2) aus Silizium, wobei die Passivierungsschicht (3) amorph oder polykristallin ist;
d) Wachstum einer polykristallinen Ladungsfängerschicht (4) auf der Passivierungsschicht (3);
wobei das Verfahren **dadurch gekennzeichnet ist, dass** Schritt c) umfasst:
- Karbonisieren der Oberfläche der epitaktischen Schicht (2) aus Silizium, um eine Passivierungsschicht (3) auszubilden, die aus polykristallinem Siliziumkarbid besteht, wobei das Karbonisieren unter einem Partialdruck eines einzelnen Kohlenstoffvorläufergases durchgeführt wird, der niedriger als der Atmosphärendruck ist, oder
- Nitrieren der Oberfläche der epitaktischen Schicht (2) aus Silizium, um eine Passivierungsschicht (3) aus Siliziumnitrid auszubilden, wobei das Nitrieren unter Partialdruck eines Stickstoffvorläufergases bei einem Druck zwischen 0,1 Torr, das heißt 13,3322 Pa, und 760 Torr, das heißt 101325 Pa, durchgeführt wird.

2. Verfahren nach dem vorstehenden Anspruch, wobei das Karbonisieren in Schritt c) die Exposition des Basissubstrats (12) gegenüber einem einzelnen Kohlenstoffvorläufer bei einem Druck unterhalb des Atmosphärendrucks zum Ausbilden einer Passivierungsschicht (3) aus polykristallinem Siliziumkarbid von mindestens 5 nm auf der Oberfläche der epitaktischen Schicht (2) aus Silizium umfasst.

3. Verfahren nach dem vorstehenden Anspruch, wobei der einzelne Kohlenstoffvorläufer eine Temperatur zwischen 700 °C und 1200 °C aufweist.

4. Verfahren nach einem der Ansprüche 1 bis 3, wobei die Passivierungsschicht (3) eine Dicke von mindestens 10 nm aufweist.

5. Verfahren nach einem der Ansprüche 1 bis 4, wobei die Ladungsfängerschicht (4) eine Dicke von mehr als 5 oder 10 Mikrometer aufweist.

6. Verfahren nach einem der Ansprüche 1 bis 5, wobei die Ladungseinfangschicht (4) aus polykristallinem Silizium isst.

7. Verfahren nach einem der Ansprüche 1 bis 6, wobei die Schritte b), c) und d) alle nacheinander *in situ* in einer Epitaxieeinrichtung ausgeführt werden.

8. Verfahren nach dem vorstehenden Anspruch, wobei Schritt b) in einem ersten Reaktor erfolgt und die Schritte c) und d) in einem zweiten Reaktor erfolgen, und wobei die Übergabe des Basissubstrats (12) von dem ersten Reaktor an den zweiten ohne Unterbrechung des Vakuums erfolgt.

9. Handhabungssubstrat (100) für eine Verbundstruktur aus dem Verfahren nach einem der Ansprüche 1 bis 8.

10. Verbundstruktur (110) für Hochfrequenzanwendungen, umfassend:
- ein Handhabungssubstrat (100) nach dem vorstehenden Anspruch,
- eine dielektrische Schicht (5) auf und in Kontakt mit der Ladungsfängerschicht (4),
- einen dünnen Film (6) auf der dielektrischen Schicht (5), der für Hochfrequenzvorrichtungen geeignet ist.

## Claims

1. Method for forming a handling substrate (100) for a composite structure, the method comprising:
a) providing a monocrystalline silicon wafer (1) obtained by Czochralski pulling, the wafer having a resistivity of between 10 and 500 ohm.cm;
b) growing a silicon epitaxial layer (2) on the monocrystalline silicon wafer (1) obtained by Czochralski pulling in order to form a base substrate (12), said silicon epitaxial layer (2) having a resistivity greater than 2000 ohm.cm and a thickness ranging from 2 to 100 micrometers;
c) forming a passivation layer (3) on the silicon epitaxial layer (2), said passivation layer (3) being amorphous or polycrystalline;
d) growing a polycrystalline charge trapping layer (4) on the passivation layer (3);
the method being **characterized in that** step c) comprises:
- carbonizing the surface of the silicon epitaxial layer (2) so as to form a passivation layer (3) made of polycrystalline silicon carbide, the carbonization being carried out under partial pressure of a single carbon precursor gas below atmospheric pressure, or
- nitriding the surface of the silicon epitaxial layer (2) so as to form a silicon nitride passivation layer (3), the nitridation being carried out under partial pressure of a nitrogen precursor gas at a pressure of between 0.1 Torr, i.e. 13.3322 Pa, and 760 Torr, i.e. 101325 Pa.

2. Method according to the preceding claim, wherein the carbonization in step c) comprises exposing the base substrate (12) to a single carbon precursor at a pressure below atmospheric pressure in order to form a polycrystalline silicon carbide passivation layer (3) of at least 5 nm on the surface of the silicon epitaxial layer (2).

3. Method according to the preceding claim, wherein said single carbon precursor has a temperature of between 700°C and 1200°C.

4. Method according to any of claims 1 to 3, wherein the passivation layer (3) has a thickness of at least 10 nm.

5. Method according to any of claims 1 to 4, wherein the charge trapping layer (4) has a thickness greater than 5 or 10 micrometers.

6. Method according to any of claims 1 to 5, wherein the charge trapping layer (4) is made of polycrystalline silicon.

7. Method according to any of claims 1 to 6, wherein steps b), c) and d) are all carried out successively *in situ* in an epitaxy apparatus.

8. Method according to the preceding claim, wherein step b) is carried out in a first reactor and steps c) and d) are carried out in a second reactor, and wherein the base substrate (12) is transferred from the first reactor to the second reactor without breaking the vacuum.

9. Handling substrate (100) for a composite structure, produced by the method according to any of claims 1 to 8.

10. Composite structure (110) for radio frequency applications, comprising:
- a handling substrate (100) according to the preceding claim,
- a dielectric layer (5) on and in contact with the charge trapping layer (4),
- a thin film (6) on the dielectric layer (5), suitable for radio-frequency devices.
